# EUROPÄISCHE PATENTSCHRIFT

(11) **EP 2 801 872 B1**
(45) Veröffentlichungstag und Bekanntmachung des Hinweises auf die Patenterteilung: **06.06.2018**
(21) Anmeldenummer: 13166604.2
(22) Anmeldetag: 06.05.2013
(51) Int. Cl.: G05B 17/02

(54) **Testeinrichtung zum Test eines virtuellen Steuergeräts**
Test device for testing a virtual control device
Dispositif de test pour le test d'un appareil de commande virtuel

(43) Veröffentlichungstag der Anmeldung: 12.11.2014
(73) Patentinhaber: dSPACE digital signal processing and control engineering GmbH, 33102 Paderborn (DE)
(72) Erfinder: Franzen, Ortwin Ludger, 33175 Bad Lippspringe (DE); Krügel, Karsten, 33106 Paderborn (DE)

(56) Entgegenhaltungen:
- EP-A2- 1 933 214
- DE-A1- 3 839 211
- US-A1- 2010 100 365
- US-A1- 2012 232 869

## Beschreibung

Die Erfindung betrifft eine Testeinrichtung zum Test zumindest eines Teils eines virtuellen Steuergeräts mit einer Simulationsumgebung in einem Simulator, aufweisend das virtuelle Steuergerät und die Simulationsumgebung, wobei das virtuelle Steuergerät wenigstens eine Software-Komponente mit wenigstens einer äußeren Datenschnittstelle umfasst, wobei die Simulationsumgebung wenigstens eine Datenschnittstelle zum zumindest mittelbaren Datenaustausch mit dem virtuellen Steuergerät umfasst.
Unter nicht-virtuellen, also "realen" Steuergeräten werden heutzutage zumeist Kleinrechner mit einer I/O-Schnittstelle (I/O = Input/Output) verstanden, die oft mit einem echtzeitfähigen Betriebssystem ausgestattet sind, das die Realisierung - auch komplexer - zumeist regelungstechnischer Aufgaben auf dem Steuergerät gestattet. Die Steuergeräte-Entwicklung ist zentraler Bestandteil der technischen Entwicklung von umfangreichen gerätetechnischen Anlagen, wie sie aus der industriellen Praxis bekannt sind. Beispielhaft zu nennen ist der Einsatz von Steuergeräten im automotiven Bereich, wie aus der US 2010/0100365 A1 bekannt, in der Luft- und Raumfahrt und in industriellen produktionstechnischen Anlagen.
Der Test des im Endprodukt zum Einsatz kommenden Serien-Steuergeräts ist der Endpunkt einer Mehrzahl vorgelagerter Entwicklungsschritte einer auf dem Steuergerät zu implementierenden Regelung oder Steuerung, wobei diese Entwicklungsschritte üblicherweise mit dem sogenannten V-Modell oder auch V-Zyklus beschrieben werden. Am Anfang der für die Funktion vieler technischer Anlagen essentiellen Reglerentwicklung steht die mathematische Modellierung des Regelungsalgorithmus auf einem Rechner mit einer mathematisch-graphischen Modellierungsumgebung, wobei der Regler als Bestandteil des Steuergeräts aufzufassen ist. Zusätzlich wird auch die Umgebung des Steuergeräts mathematisch modelliert, da die Interaktion des Reglers auf dem Steuergerät mit dem zu steuernden Prozess von Interesse ist. Bei diesen funktionalen mathematischen Betrachtungen ist eine Simulation in Echtzeit meist nicht erforderlich (Offline-Simulation).

Im nächsten Schritt wird der zuvor entworfene Regelungsalgorithmus mit Hilfe des Rapid-Control-Prototyping auf eine leistungsfähige, meist echtzeitfähige Hardware übertragen, die über geeignete I/O-Schnittstellen mit dem tatsächlichen physikalischen Prozess verbunden ist, also beispielsweise mit einem Kraftfahrzeug-Motor. Diese echtzeitfähige Hardware hat mit dem später zum Einsatz kommenden Serien-Steuergerät im Regelfall nichts zu tun, es geht hier um den Nachweis der prinzipiellen Funktionsfähigkeit der zuvor entworfenen Regelung in der Praxis.

In einem weiteren Schritt wird im Rahmen der automatischen Seriencodegenerierung die Regelung auf dem später im Serien-Steuergerät wahrscheinlich tatsächlich zum Einsatz kommenden Zielprozessor implementiert. Die Zielhardware nähert sich demnach in diesem Schritt dem Serien-Steuergerät an, ist mit dem Serien-Steuergerät aber nicht identisch. In einem weiteren Schritt wird das üblicherweise erst in einem späten Entwicklungsstadium vorhandene Serien-Steuergerät im Rahmen eines Hardware-in-the-Loop-Tests (HIL) überprüft. Das in diesem Schritt physikalisch vorhandene Serien-Steuergerät wird hier mittels seiner physikalischen Steuergeräteschnittstelle mit einem leistungsfähigen Simulator verbunden. Der Simulator simuliert die benötigten Größen des zu testenden Serien-Steuergeräts und tauscht Ein- und Ausgangsgrößen mit dem Serien-Steuergerät aus. Die Pins der physikalischen Steuergeräte-Schnittstelle des Serien-Steuergeräts sind über einen Kabelbaum mit dem Simulator verbunden. So ist es möglich, in der Simulationsumgebung alle benötigten Größen eines Kraftfahrzeug-Motors - gegebenenfalls das gesamte Kraftfahrzeug mit Motor, Antriebstrang, Fahrwerk und Fahrstrecke - zu simulieren und das Verhalten des Serien-Steuergeräts im Zusammenspiel mit der Simulationsumgebung gefahrlos zu überprüfen.

Das so im Rahmen der HIL-Simulation getestete Serien-Steuergerät wird letztendlich in dem "echten" Zielsystem, also beispielsweise in einem Kraftfahrzeug verbaut und in der echten physikalischen Umgebung getestet, die zuvor in der Simulationsumgebung nur vorgetäuscht worden ist.

Der zuvor skizzierte Entwicklungsprozess bei der Reglerentwicklung hat sich außerordentlich bewährt. Der Entwicklungsprozess bringt es jedoch mit sich, dass das Serien-Steuergerät erst ganz am Ende der Entwicklung in den Entwicklungsprozess eingebunden wird und damit auch erst in späten Entwicklungsständen überprüft wird. Bevor das Serien-Steuergerät tatsächlich vorliegt, können mit dem aufgezeigten Entwicklungsprozess nur Funktionalitäten auf abstrakter funktioneller Ebene getestet werden, also praktisch nur auf der Ebene der Applikationssoftware. Ein guter Teil der später auf dem Serien-Steuergerät zum Einsatz kommenden Software-Komponenten wird in frühen Entwicklungsständen nicht mitgetestet. Zu diesen Software-Komponenten gehört beispielsweise das Runtime-Environment, die zwischen der Applikationssoftware und den hardwarenahen Softwareschichten vermittelt. Hardwarenähere Softwarekomponenten sind beispielsweise das Betriebssystem und plattform-unabhängige Basissoftware (Systemdienste, Kommunikationsdienste, I/O-Hardware-Abstraktionsschicht usw.) und schließlich plattform-abhängige Teile des Betriebssystems und der Basissoftware.

Um diese umfangreichen Anteile des Serien-Steuergeräts frühzeitig in den Entwicklungsprozess einzubeziehen, werden die zuvor genannten Software-Komponenten - zumindest teilweise - im Rahmen eines sogenannten virtuellen Steuergeräts nachgebildet und in einem Simulator simuliert (dSPACE Catalog 2012: "SystemDesk V-ECU Generation Module" und "dSPACE Offline Simulator"). In dem Simulator interagiert jedenfalls das virtuelle Steuergerät mit der ebenfalls in dem Simulator vorhandenen Simulationsumgebung. Die Interaktion geschieht durch Austausch von Daten über die wenigstens eine äußere Datenschnittstelle einer Software-Komponente des virtuellen Steuergeräts und eine Datenschnittstelle der Simulationsumgebung. Welche Software-Komponenten des virtuellen Steuergeräts eine äußere Datenschnittstelle zur Verfügung stellen, hängt davon ab, welche der zuvor genannten Software-Schichten in dem virtuellen Steuergerät abgebildet werden. Wenn in dem virtuellen Steuergerät lediglich die abstrakte Applikationssoftware abgebildet ist, dann stellen die Software-Komponenten der Applikationssoftware die äußeren Datenschnittstellen zur Simulationsumgebung. Wenn dagegen zusätzlich auch das Runtime-Environment Bestandteil des virtuellen Steuergeräts ist, werden die äußeren Datenschnittstellen durch deren Software-Komponenten zur Verfügung gestellt. Wenn noch tiefer liegende Softwareschichten abgebildet werden, beispielsweise des Betriebssystems oder Basissoftwarekomponenten, dann stellen diese Software-Komponenten die äußere Datenschnittstelle zur Simulationsumgebung.

Es ist erkennbar, dass die Simulationsumgebung sich jeweils an die äußere Datenschnittstelle der Software-Komponenten des virtuellen Steuergeräts anpassen muss in Abhängigkeit von den in dem virtuellen Steuergerät nachgebildeten Software-Komponenten. Jede Änderung des virtuellen Steuergeräts, die eine Software-Komponente mit einer äußeren Datenschnittstelle betrifft, zieht unweigerlich auch eine Änderung der Simulationsumgebung und der Datenschnittstelle der Simulationsumgebung nach sich, was arbeitsintensiv ist und Fehlerquellen im Entwicklungsprozess mit sich bringt. Nachteilig ist auch, dass die auf ein bestimmtes virtuelles Steuergerät angepasste Simulationsumgebung im Rahmen der HIL-Simulation - also wenn das Steuergerät physikalisch vorhanden ist und nicht mehr nur virtuell vorliegt - häufig nicht unmittelbar verwendet werden kann, da die für eine solche Verwendung erforderliche Bereitstellung von pinbezogenen Größen der physikalischen Steuergeräteschnittstelle an der Datenschnittstelle der Simulationsumgebung nicht gegeben ist.

Es ist daher Aufgabe der vorliegenden Erfindung, eine Einrichtung zum Test zumindest eines Teils eines virtuellen Steuergeräts mit einer Simulationsumgebung in einem Simulator zur Verfügung zu stellen, bei der die Abhängigkeiten zwischen dem virtuellen Steuergerät und der Simulationsumgebung reduziert werden.

Die zuvor hergeleitete Aufgabe wird bei der eingangs beschriebenen Testeinrichtung zunächst und im Wesentlichen dadurch gelöst, dass eine virtuelle Steuergeräte-Pin-Einheit wenigstens eine virtuelle Steuergeräteschnittstelle aufweist und mittels der virtuellen Steuergeräteschnittstelle zumindest mit der äußeren Datenschnittstelle der Software-Komponente des virtuellen Steuergeräts verbunden ist, dass die virtuelle Steuergeräte-Pin-Einheit wenigstens eine Simulationsumgebungsschnittstelle aufweist und mit der Simulationsumgebungsschnittstelle mit der Datenschnittstelle der Simulationsumgebung verbunden ist und dass die virtuelle Steuergeräte-Pin-Einheit wenigstens einen virtuellen Steuergeräte-Pin aufweist, der mit einem Pin der physikalischen Schnittstelle eines zu simulierenden realen Steuergeräts korrespondiert, wobei über den virtuellen Steuergeräte-Pin ein virtuelles physikalisches Steuergerätesignal übertragbar ist.

Die erfindungsgemäß vorgesehene virtuelle Steuergeräte-Pin-Einheit vermittelt zwischen dem virtuellen Steuergerät und der Simulationsumgebung, was grundsätzlich die Möglichkeit eröffnet, die Simulationsumgebung und deren Datenschnittstelle auch bei einer Veränderung des virtuellen Steuergeräts unverändert zu lassen. Die zusätzliche Zurverfügungstellung eines virtuellen Steuergeräte-Pins bringt darüber hinaus die Möglichkeit mit sich, jene Schnittstelle zu definieren, die das reale Steuergerät zwingend auch aufweisen muss, nämlich das virtuelle Abbild der physikalischen Schnittstelle des realen Steuergeräts. Dies eröffnet auf dem Simulator eine pinbezogene Definition und Handhabung der Schnittstelle zwischen dem virtuellen Steuergerät und der Simulationsumgebung.

Die über einen virtuellen Steuergeräte-Pin der virtuellen Steuergeräte-Pin-Einheit ausgetauschten Informationen sind insoweit ein "virtuelles physikalisches Steuergerätesignal", als dass es sich hier zwar nicht um die echten physikalischen Steuergerätesignale des realen Steuergeräts handelt, also um Spannungen, Ströme, Anschlusswiderstände, aber diese physikalischen Größen werden berechnet und wertemäßig als entsprechende Daten ausgetauscht. Wenn in dem virtuellen Steuergerät nur abstraktere Softwareschichten abgebildet sind, also beispielsweise die Applikationssoftware oder das Runtime-Environment, dann kann die äußere Datenschnittstelle des virtuellen Steuergeräts nur abstrakt funktional sein, aber keine signalmäßige Nachbildung des echten Steuergeräts liefern. Falls beispielsweise von einer Komponente der Applikationssoftware ein Druckwert oder ein Temperaturwert geliefert wird (z. B. 950 bar, 275 °C), aber keine entsprechende elektrisch codierte Größe, die bei dem realen Steuergerät über Pins der physikalischen Schnittstelle ausgetauscht wird, beispielsweise in Form einer Spannung, in Form eines Stromes (2 bis 20 mA-Schnittstelle) oder in Form eines modulierten Signals, kann die virtuelle Steuergeräte-Pin-Einheit diese Lücke nunmehr schließen, indem sie an wenigstens einen virtuellen Steuergeräte-Pin genau ein solches virtuelles physikalisches Steuergerätesignal, also den Wert des entsprechenden realen physikalischen Steuergerätesignals, überträgt.

Gemäß einem vorteilhaften Ausführungsbeispiel ist bei der Testeinrichtung vorgesehen, dass die Simulationsumgebungsschnittstelle der virtuellen Steuergeräte-Pin-Einheit zumindest einen virtuellen Steuergeräte-Pin aufweist, so dass über die Datenschnittstelle der Simulationsumgebung auch virtuelle physikalische Steuergerätesignale übertragbar sind. Dies ist deshalb besonders vorteilhaft, weil die Datenschnittstelle der Simulationsumgebung dann automatisch an die physikalischen Steuergerätesignale der physikalischen Schnittstelle des realen Steuergeräts angepasst ist. Die so eingerichtete Simulationsumgebung ist dann auch unmittelbar dazu geeignet, auf einem HIL-Simulator betrieben zu werden zusammen mit einem über eine physikalische I/O-Schnittstelle verbundenen realen Steuergerät, wie es bei HIL-Simulationen üblich ist.

Bei einer Weiterbildung der erfindungsgemäßen Testeinrichtung ist vorgesehen, dass die Simulationsumgebungsschnittstelle der virtuellen Steuergeräte-Pin-Einheit vollständig aus virtuellen Steuergeräte-Pins gebildet ist, so dass über die Datenschnittstelle der Simulationsumgebung ausschließlich virtuelle physikalische Steuergerätesignale übertragen werden. Der Vorteil einer so ausgestalteten virtuellen Steuergeräte-Pin-Einheit besteht darin, dass die Simulationsumgebung praktisch über den gesamten Entwicklungsprozess unverändert bleiben kann, jedenfalls nicht verändert werden muss, wenn sich die äußere Datenschnittstelle einer Software-Komponente des virtuellen Steuergeräts ändert. Die Simulationsumgebung ist unabhängig von der Hardwarenähe des virtuellen Steuergeräts.

Bei einer anderen vorteilhaften Weiterbildung der erfindungsgemäßen Testeinrichtung ist vorgesehen, dass die Simulationsumgebungsschnittstelle der virtuellen Steuergeräte-Pin-Einheit keinen virtuellen Steuergeräte-Pin aufweist, so dass die virtuelle Steuergeräte-Pin-Einheit eine direkte Verbindung zwischen dem virtuellen Steuergerät und der Simulationsumgebung herstellt und die virtuelle Steuergeräte-Pin-Einheit den wenigstens einen virtuellen Steuergeräte-Pin außerhalb der Simulationsumgebungsschnittstelle aufweist. Über einen solchen virtuellen Steuergeräte-Pin kann überprüft werden, ob sich die erwarteten Signale an einem virtuellen Steuergeräte-Pin einstellen, so dass hier eine signalmäßige Überprüfung des virtuellen Steuergeräts ermöglicht wird, auch wenn die Simulationsumgebung selbst die virtuellen physikalischen Steuergerätesignale nicht nutzt.

Insgesamt ergibt sich aus dem zuvor gesagten, dass selbstverständlich auch Mischformen der Ausführungsbeispiele möglich sind. So können beispielsweise virtuelle Steuergeräte-Pins vorgesehen sein sowohl als Bestandteil der Simulationsumgebungsschnittstelle als auch außerhalb der Simulationsumgebungsschnittstelle.

Bei einem bevorzugten Ausführungsbeispiel der erfindungsgemäßen Testeinrichtung ist weiterhin vorgesehen, dass die virtuelle Steuergeräte-Pin-Einheit wenigstens eine Korrespondenz aufweist zwischen einerseits einem zwischen dem virtuellen Steuergerät und/oder der virtuellen Steuergeräte-Pin-Einheit und/oder der Simulationsumgebung austauschbaren Datum und andererseits der mit der Bestimmung dieses austauschbaren Datums in Zusammenhang stehender virtueller Steuergeräte-Pins. Durch diese Korrespondenz ist es in der virtuellen Steuergeräte-Pin-Einheit möglich, diejenigen virtuellen Steuergeräte-Pins zu ermitteln, die für die Bestimmung des insgesamt auszutauschenden Datums von Bedeutung sind, beispielsweise weil deren zugehörige virtuelle physikalische Steuergerätesignale zur Bestimmung des austauschbaren Datums benötigt werden. Bei einer Weiterbildung der zuvor genannten Testeinrichtung ist vorgesehen, dass zu den von der Korrespondenz umfassten virtuellen Steuergeräte-Pins auch jeweils eine Ermittlungsvorschrift zur Bestimmung der zugehörigen virtuellen physikalischen Steuergerätesignale in der virtuellen Steuergeräte-Pin-Einheit abgelegt ist. Dadurch wird die virtuelle Steuergeräte-Pin-Einheit in die Lage versetzt, die entsprechenden virtuellen physikalischen Steuergerätesignale zu ermitteln, entweder selbständig, oder durch Anstoßen der Berechnung dieser virtuellen physikalischen Steuergerätesignale an anderer Stelle, beispielsweise in der Simulationsumgebung.

Die eingangs hergeleitete Aufgabe wird ferner auch gelöst mit einer virtuellen Steuergeräte-Pin-Einheit zur virtuellen Abbildung einer pinbezogenen physikalischen Schnittstelle eines zu simulierenden realen Steuergeräts, wobei die virtuelle Steuergeräte-Pin-Einheit wenigstens eine virtuelle Steuergeräteschnittstelle, wenigstens eine Simulationsumgebungsschnittstelle und wenigstens einen virtuellen Steuergeräte-Pin aufweist, wobei mittels der virtuellen Steuergeräteschnittstelle eine Datenverbindung mit wenigstens einer äußeren Schnittstelle einer Software-Komponente eines virtuellen Steuergeräts herstellbar ist, wobei mit der Simulationsumgebungsschnittstelle wenigstens eine Datenverbindung mit der Datenschnittstelle einer Simulationsumgebung herstellbar ist und wobei der virtuelle Steuergeräte-Pin mit einem Pin der physikalischen Schnittstelle eines zu simulierenden realen Steuergeräts korrespondiert, wobei über den virtuellen Steuergeräte-Pin ein virtuelles physikalisches Steuergerätesignal übertragbar ist.

Die erfindungsgemäße virtuelle Steuergeräte-Pin-Einheit zeichnet sich darüber hinaus durch die Eigenschaften aus, die zuvor in Zusammenhang mit der erfindungsgemäßen Testeinrichtung und der dort realisierten virtuellen Steuergeräte-Pin-Einheit dargestellt worden sind.

Im Einzelnen gibt es nun eine Vielzahl von Möglichkeiten, die erfindungsgemäße Testeinrichtung und die erfindungsgemäße virtuelle Steuergeräte-Pin-Einheit auszugestalten und weiterzubilden. Dazu wird auf die den Patentansprüchen 1 und 10 nachgeordneten Patentansprüche sowie auf die nachfolgende Beschreibung bevorzugter Ausführungsbeispiele der Erfindung unter Bezugnahme auf die Zeichnung verwiesen. In der Zeichnung zeigen
- Fig. 1: eine aus dem Stand der Technik bekannter Testaufbau zum Test eines realen Steuergeräts mit einem Simulator,
- Fig. 2: eine aus dem Stand der Technik bekannte Testeinrichtung zum Test eines virtuellen Steuergeräts mit einer Simulationsumgebung,
- Fig. 3: ein erstes Ausführungsbeispiel für eine erfindungsgemäße Testeinrichtung zum Test eines virtuellen Steuergeräts mit einer virtuellen Steuergeräte-Pin-Einheit,
- Fig. 4: ein weiteres Ausführungsbeispiel für eine erfindungsgemäße Testeinrichtung zum Test eines virtuellen Steuergeräts mit einer virtuellen Steuergeräte-Pin-Einheit,
- Fig. 5: ein weiteres Ausführungsbeispiel für eine erfindungsgemäße Testeinrichtung mit einer virtuellen Steuergeräte-Pin-Einheit und
- Fig. 6a, 6b: eine Darstellung der Realisierung des Datenaustausches zwischen dem virtuellen Steuergerät, der virtuellen Steuergeräte-Pin-Einheit und der Simulationsumgebung.

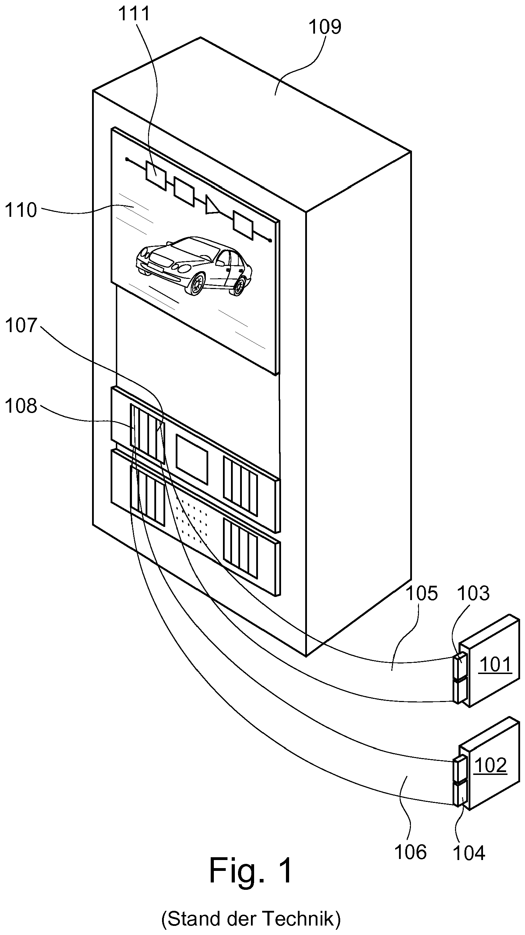

Zur Erläuterung der erfindungsgemäßen Testeinrichtung ist in Fig. 1 zunächst dargestellt ein aus dem Stand der Technik bekannter Testaufbau nach dem Prinzip des Hardware-in-the-Loop-Tests. In dem dargestellten Testaufbau kommen keine virtuellen Steuergeräte vor, Gegenstand des Tests sind die realen Steuergeräte 101, 102. Die realen Steuergeräte 101, 102 sind mit ihren physikalischen Schnittstellen 103, 104 und über Kabelbäume 105, 106 mit entsprechenden I/O-Schnittstellen 107, 108 eines Simulators 109 verbunden. Der Simulator 109 selbst weist neben den I/O-Schnittstellen 107, 108 auch eine Simulationsumgebung 110 auf, die ein mathematisches Fahrzeugmodell zum Gegenstand hat, angedeutet durch das Blockschaltbild 111. Der in Fig. 1 dargestellte Testaufbau ergibt sich erst dann, wenn die Seriensteuergeräte 101, 102 am Ende des Entwicklungsprozesses vorliegen. Erst in dieser Situation ist es möglich, die Software-Komponenten der realen Steuergeräte 101, 102 im Zusammenspiel mit dem Simulator zu testen.

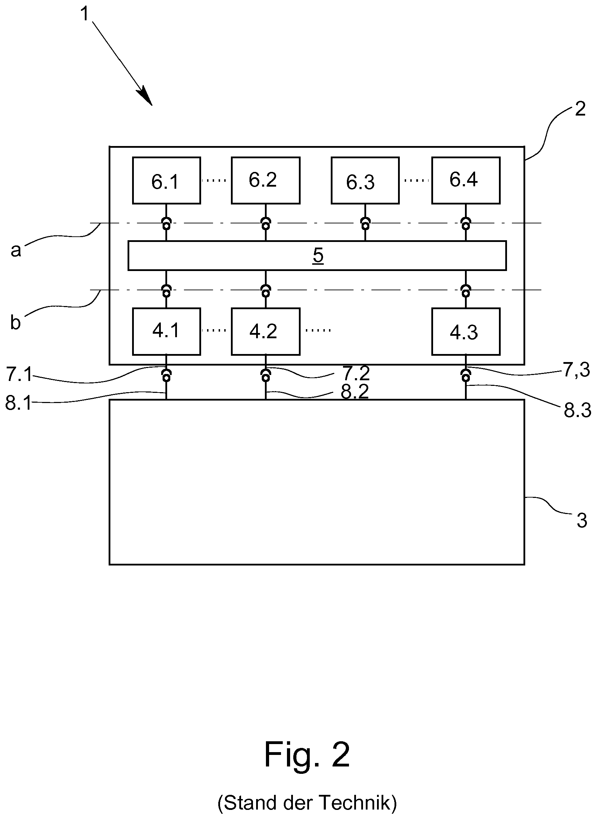

Um auch schon in vorangehenden Schritten der Reglerentwicklung die Komponenten der später auf den realen Steuergeräten 101, 102 zu betreibenden Software zu ermöglichen, sind die in Fig. 2 schematisch dargestellten und aus dem Stand der Technik bekannten Testeinrichtungen 1 eingeführt worden, die den Test eines virtuellen Steuergeräts 2 mit einer Simulationsumgebung 3 ermöglichen. Derartige Testeinrichtungen 1 werden auf einem Simulator betrieben, der in den Figuren 2 bis 6 nicht explizit dargestellt ist.

Das virtuelle Steuergerät 2 umfasst mehrere Software-Komponenten 4, 5, 6, die zu unterschiedlich abstrakten Softwareschichten gehören. Die verschiedenen Softwareschichten sind in Fig. 2 durch waagerechte Linien a, b angedeutet. In dem dargestellten Ausführungsbeispiel sind die Software-Komponenten 6.1, 6.2, 6.3 und 6.4 Komponenten der Applikationsschicht, in der Software vollkommen maschinenunabhängig, also unabhängig von der Zielplattform, implementiert ist. Alle darunter liegenden Softwareschichten sind hardwarenäher. Die Software-Komponente 5 umfasst im dargestellten Ausführungsbeispiel das Runtime-Environment, und die Software-Komponenten 4.1, 4.2 und 4.3 umfassen plattform-unabhängige wie auch plattformabhängige Basissoftware, beispielsweise in Form des Betriebssystems und in Form von verschiedenen Kommunikationsdiensten. Bei den Software-Komponenten 4, 5, 6 handelt es sich um Software-Komponenten, die später auf dem realen Steuergerät auch zum Einsatz kommen sollen, die Software-Komponenten werden im Rahmen eines virtuellen Steuergeräts 2 aber auf einem Simulator betrieben, der gerätemäßig vollkommen verschieden von dem späteren realen Steuergerät ist.

Die Software-Komponenten 4 stehen in Verbindung mit der Simulationsumgebung 3. Dazu weisen die Software-Komponenten 4 äußere Datenschnittstellen 7.1, 7.2 und 7.3 auf. Entsprechend weist die Simulationsumgebung Datenschnittstellen 8.1, 8.2. und 8.3 auf. Das in Figur 2 dargestellte virtuelle Steuergerät 2 ist sehr hardwarenah modelliert. Dies ist in der Praxis nicht immer der Fall, in einer anderen Modellierung des virtuellen Steuergeräts 2 könnten beispielsweise nur die Software-Komponenten 6.1 bis 6.4 auf der Applikationsebene vorkommen, so dass ein solches virtuelles Steuergerät über die Software-Komponenten 4 und 5 nicht verfügte. In diesem Fall wären die Schnittstellen der Software-Komponenten 6 die äußeren Datenschnittstellen, weil sie in Verbindung mit der Simulationsumgebung 3 stehen müssten, um einen Datenaustausch gewährleisten zu können. An diesem Beispiel ist erkennbar, dass eine Veränderung des virtuellen Steuergeräts 2 im Stand der Technik eine umfassende Anpassung der Simulationsumgebung 3 nach sich ziehen muss, was entsprechende Nachteile - Softwarepflege, fehlerträchtige Änderungen usw. - mit sich bringt.

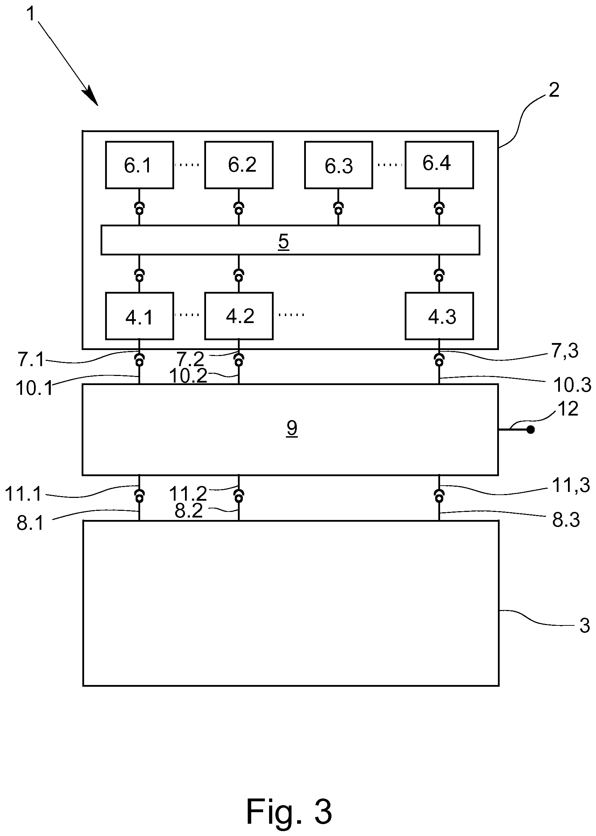

In Fig. 3 ist nun eine erfindungsgemäße Testeinrichtung 1 mit einem virtuellen Steuergerät 2 und mit einer Simulationsumgebung 3 dargestellt, wobei nunmehr aber auch eine zwischen dem virtuellen Steuergerät 2 und der Simulationsumgebung 3 vermittelnde virtuelle Steuergeräte-Pin-Einheit 9 vorgesehen ist. Die virtuelle Steuergeräte-Pin-Einheit 9 weist virtuelle Steuergeräteschnittstellen 10.1, 10.2, 10.3 auf, mittels derer die virtuelle Steuergeräte-Pin-Einheit 9 mit den äußeren Datenschnittstellen 7.1, 7.2, 7.3 der Softwarekomponenten 4.1, 4.2, 4.3 des virtuellen Steuergeräts 2 verbunden ist. Die virtuelle Steuergeräte-Pin-Einheit 9 weist ferner Simulationsumgebungsschnittstellen 11.1, 11.2, 11.3 auf und ist mittels der Simulationsumgebungsschnittstellen 11.1, 11.2, 11.3 mit den Datenschnittstellen 8.1, 8.2, 8.3 der Simulationsumgebung 3 verbunden. Da es sich hier sämtlich um auf einem Rechner realisierte Komponenten handelt, sind die Schnittstellen nicht körperlich zu verstehen, sie sind funktional zu verstehen in dem Sinne, dass über die geschafften Schnittstellen Daten ausgetauscht werden können.

Die virtuelle Steuergeräte-Pin-Einheit 9 weist ferner einen virtuellen Steuergeräte-Pin 12 auf, der mit einem Pin der physikalischen Schnittstelle eines zu simulierenden realen Steuergerätes korrespondiert, wobei über den virtuellen Steuergeräte-Pin 12 ein virtuelles physikalisches Steuergerätesignal übertragbar ist. Mit dem virtuellen Steuergeräte-Pin 12 wird also ein Pin einer physikalischen Schnittstelle eines realen Steuergeräts nachgebildet. Demgemäß werden hier in Form von Daten solche Größen übermittelt, die physikalischen Steuergerätesignalen dieses Pins entsprechen. Der virtuelle Steuergeräte-Pin 12 ermöglicht demnach eine Sicht auf das virtuelle Steuergerät 2, die durch die physikalischen Signalformen der realen physikalischen Schnittstelle des nachzuahmenden realen Steuergeräts vorgegeben ist. Wenn beispielsweise eine Temperatur auf der Applikationsebene des virtuellen Steuergeräts 2 in Form der Angabe T = 20° C gehandhabt wird, dann wird diese gleiche Information über einen virtuellen Steuergeräte-Pin 12 beispielsweise als ein Signal U = 2,35 V ausgegeben. Die virtuelle Steuergeräte-Pin-Einheit 9 ermöglicht jedenfalls die Signalsicht auf das virtuelle Steuergerät 2, wobei diese Signalsicht in unterschiedlicher Weise genutzt werden kann.

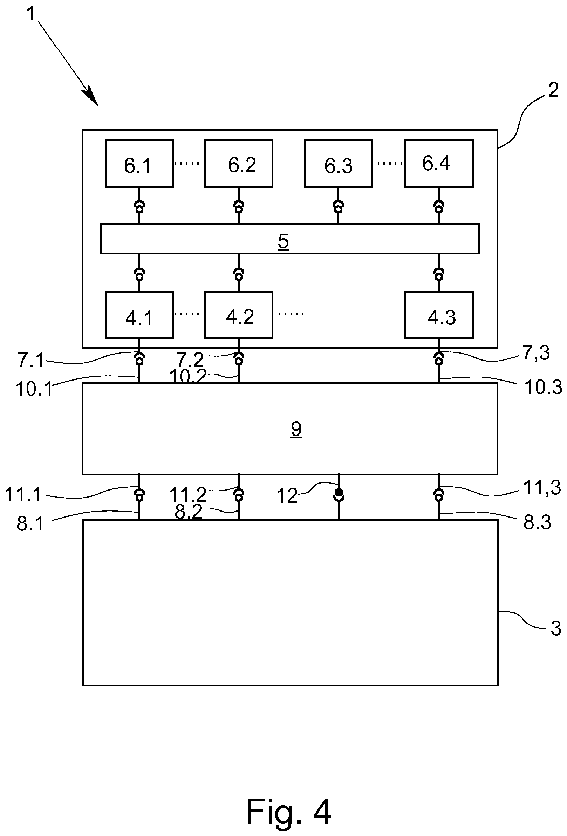

In dem Ausführungsbeispiel gemäß Fig. 4 umfasst die Simulationsumgebungsschnittstelle 11 der virtuellen Steuergeräte-Pin-Einheit 9 den virtuellen Steuergeräte-Pin 12, so dass über die Datenschnittstelle 8 der Simulationsumgebung 3 auch virtuelle physikalische Steuergerätesignale übertragen werden können.

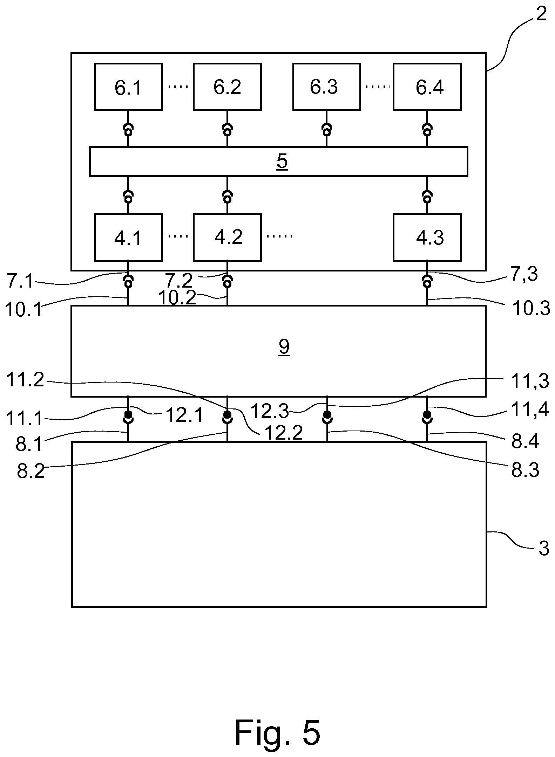

In dem Ausführungsbeispiel gemäß Fig. 5 besteht die Simulationsumgebungsschnittstelle 11 der virtuellen Steuergeräte-Pin-Einheit 9 vollständig aus virtuellen Steuergeräte-Pins 12, so dass über die Datenschnittstelle 8 der Simulationsumgebung 3 ausschließlich virtuelle physikalische Steuergerätesignale übertragen werden. Dies ist vorteilhaft, weil die Simulationsumgebung 3 damit vollständig unabhängig von Veränderungen in der Modellierung des virtuellen Steuergeräts 2 ist. Die gemäß Fig. 5 gebildete Simulationsumgebung 3 kann praktisch unverändert in einem Simulator verwendet werden, wenn das virtuelle Steuergerät 2 durch ein reales Steuergerät ersetzt wird, weil die Simulationsumgebung 3 schon auf die Pins der physikalischen Schnittstelle des realen Steuergeräts ausgerichtet ist. Selbstverständlich muss dann noch eine entsprechende I/O-Funktionalität in dem Simulator eingerichtet werden, damit die Pins der physikalischen Schnittstelle des realen Steuergeräts auch angesprochen werden können, aber funktional ist die Simulationsumgebung 3 nicht mehr zu ändern.

Die Simulationsumgebung 3 gemäß Fig. 5 kann während des gesamten Reglerentwicklungsprozesses verwendet werden, unabhängig von der - ggf. variierenden - Hardwarenähe der Modellierung des virtuellen Steuergeräts 2. Die durch Veränderung der Modellierung des virtuellen Steuergeräts 2 erforderlichen Anpassungen sind bei der virtuellen Steuergeräte-Pin-Einheit 9 vorzunehmen. Wenngleich auch die virtuelle Steuergeräte-Pin-Einheit 9 angepasst werden muss, ist die Lösung gemäß Fig. 5 dennoch vorteilhaft, da die Simulationsumgebung 3 in jedem Fall beim Übergang von dem virtuellen Test zum realen Test in einem HIL-Simulator weiterverwendet werden kann, was andernfalls nicht möglich wäre.

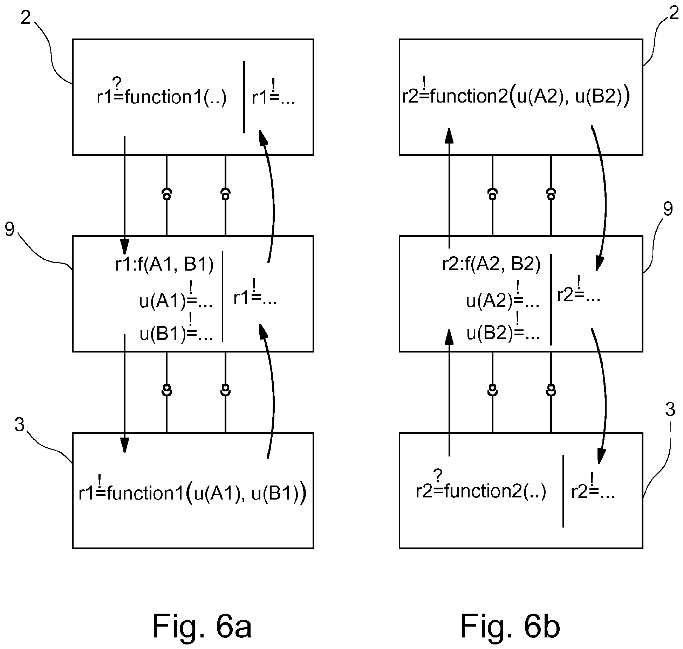

In den Figuren 6a und 6b ist jeweils dargestellt, wie der Datenaustausch zwischen dem virtuellen Steuergerät 2, der virtuellen Steuergeräte-Pin-Einheit 9 und der Simulationsumgebung 3 über die jeweiligen Schnittstellen realisiert werden kann, insbesondere für den Fall, dass virtuelle Steuergeräte-Pins 12 als ergänzende Schnittstelle der Simulationsumgebung 3 genutzt werden. In Fig. 6a ist gezeigt, dass das virtuelle Steuergerät 2 ein Datum r1 einer Schnittstelle der Simulationsumgebung 3 anfordert, hier durch einen Funktionsaufruf. Die virtuelle Steuergeräte-Pin-Einheit 9 nimmt den Funktionsaufruf entgegen und greift auf eine Korrespondenz r1:f(A1, B1) zurück, die in der virtuellen Steuergeräte-Pin-Einheit 9 hinterlegt ist. Es handelt sich hier um eine Korrespondenz zwischen einerseits einem zwischen dem virtuellen Steuergerät 2 und/oder der virtuellen Steuergeräte-Pin-Einheit 9 und/oder der Simulationsumgebung 3 austauschbarem Datum r1 und andererseits der mit der Bestimmung dieses austauschbaren Datums in Zusammenhang stehender virtueller Steuergeräte-Pins A1, B1. In der virtuelle Steuergeräte-Pin-Einheit 9 ist zu den von der Korrespondenz umfassten virtuellen Steuergeräte-Pins A1, B1 auch eine Ermittlungsvorschrift zur Bestimmung der zugehörigen virtuellen physikalischen Steuergerätesignale u(A1), u(B1) abgelegt, so dass diese virtuellen physikalischen Steuergerätesignale u(A1), u(B1) ermittelt werden können. Damit stehen praktisch die elektrischen Signalwerte der virtuellen Steuergeräte-Pins A1, B1 der Simulationsumgebung 3 zur Verfügung. Auch andere Werkzeuge, wie z. B. Experimentier- und Testautomatisierungswerkzeuge können die virtuellen physikalischen Steuergerätesignale u(A1), u(B1) unabhängig von der Verwendung in der Simulationsumgebung 3 nutzen. Die zur Berechnung des Datums r1 erforderliche Funktion 1 wird nachfolgend von der virtuellen Steuergeräte-Pin-Einheit 9 in der Simulationsumgebung 3 aufgerufen, womit das Datum r1 berechnet, an die virtuelle Steuergeräte-Pin-Einheit 9 zurückgegeben und von dort an das virtuelle Steuergerät 2 weitergeleitet wird. In einem weiteren Ausführungsbeispiel zeichnet sich die Testeinrichtung dadurch aus, dass zu den von der Korrespondenz r1:f(A1, B1) umfassten virtuellen Steuergeräte-Pins 12 auch eine Ermittlungsvorschrift zur Bestimmung des Datums r1 aus den zugehörigen virtuellen physikalischen Steuergerätesignalen u(A1), u(B1) in der virtuellen Steuergeräte-Pin-Einheit 9 abgelegt ist. Für diesen Fall ist insbesondere vorgesehen, dass die Ermittlungsvorschrift zur Bestimmung des Datums r1 aus den zugehörigen virtuellen physikalischen Steuergerätesignalen u(A1), u(B1) zeitabhängige Steuersignale auswertet, insbesondere in Form eines zeitlich begrenzten Zeitsignals oder eines zeitlich unbegrenzten Zeitsignals.

In einem weiteren Ausführungsbeispiel kann die direkte Rückmeldung eines Ergebnisses (hier: r1) entfallen, so dass eine Rückmeldung entweder gar nicht oder nur über die gleichen oder andere virtuelle physikalische Steuergerätesignale erfolgt.

In einem weiteren Ausführungsbeispiel werden die virtuellen Steuergerätepins für die o.g. Funktionalität nicht als ergänzende, sondern als alleinige Schnittstelle zur Simulationsumgebung genutzt. In diesem Fall ergibt sich die Reaktion der Simulationsumgebung (z. B. Ausführung einer Funktion function1a) alleinig aus den Änderungen der virtuellen physikalischen Steuergerätesignale (im aufgeführten Beispiel u(A1) und/oder u(B1)).

Der umgekehrte Informationsfluss ist in Fig. 6b dargestellt, der diesmal von der Simulationsumgebung 3 angestoßen wird. Der Vorgang ist analog zu dem Vorgang in Fig. 6a, zur Vermeidung von Verwechslungen sind die Bezeichner A2, B2 für die virtuellen Steuergeräte-Pins und function2 für den erforderlichen Funktionsaufruf verwendet worden.

Die in Bezug auf Fig. 6a genannten Ausführungsvarianten gelten sinngemäß entsprechend für die Rückrichtung auch in Bezug auf Fig. 6b.

Bei der in den Figuren 6a, 6b dargestellten Testeinrichtungen wird ein dediziertes Datum zwischen dem virtuellen Steuergerät 2, der virtuellen Steuergeräte-Pin-Einheit 9 und der Simulationsumgebung 3 ausgetauscht. In einem weiteren Ausführungsbeispiel ist es möglich, dass die Ermittlungsvorschrift zur Bestimmung der zugehörigen virtuellen physikalischen Steuergerätesignale u(A1), u(B1) eine zeitabhängige Funktion ist, die zur Bestimmung eines zeitabhängigen virtuellen physikalischen Zeitsignals dient. Typische zeitabhängige Signale können beispielsweise in Form eines dedizierten parametrierten Signalverlaufs (eines "Signalmusters") vorliegen oder in einem parametrierten modulierten Signal (z. B. ein PWM-Signal). Vorzugsweise ist die Ermittlungsvorschrift eine explizite Ermittlungsvorschrift in der virtuellen Steuergeräte-Pin-Einheit 9. In anderen bevorzugten Ausführungsbeispielen besteht die Ermittlungsvorschrift in einem Verweis auf wenigstens eine Ermittlungsvorschrift des virtuellen Steuergeräts und/oder wenigstens in einem Verweis auf wenigstens eine Ermittlungsvorschrift der Simulationsumgebung.

Im Fall der Fig. 6a sind die Korrespondenz und die Ermittlungsvorschrift zur Ermittlung der virtuellen physikalischen Steuergerätesignale u(A1), u(B1) durch externe Informationen in die virtuelle Steuergeräte-Pin-Einheit 9 geladen worden. Bei einem anderen, hier nicht dargestellten Ausführungsbeispiel bietet die Testeinrichtung dem Verwender eine Eingabemöglichkeit zur Hinterlegung derartiger Angaben, worauf hier nicht näher eingegangen wird.

Die virtuelle Steuergeräte-Pin-Einheit 9 der jeweils dargestellten Testeinrichtung 1 ist so ausgestaltet, dass sie sich zur Codegenerierung eignet, nämlich zur Generierung solchen Codes, der zur programmtechnischen Umsetzung der zuvor beschriebenen Funktionalitäten geeignet ist. Dabei handelt es sich insbesondere um Code zur - datenmäßigen - Verbindung der äußeren Datenschnittstelle 7 und/oder der Datenschnittstelle 8. Alternativ oder zusätzlich handelt es sich um Code zur Herstellung der Korrespondenz zwischen einerseits einem zwischen dem virtuellen Steuergerät 2 und/oder der virtuellen Steuergeräte-Pin-Einheit 9 und/oder der Simulationsumgebung 3 austauschbaren Datum r1 und andererseits der mit der Bestimmung dieses austauschbaren Datums r1 in Zusammenhang stehender virtueller Steuergeräte-Pins A1, B1. Ferner handelt es sich alternativ oder zusätzlich um Code zur Realisierung einer Ermittlungsvorschrift und/oder Berechnungsvorschrift zur Bestimmung der zugehörigen virtuellen physikalischen Steuergerätesignale u(A1), u(B1) und/oder um Code zur Realisierung eines zeitabhängigen virtuellen physikalischen Zeitsignals als virtuelles physikalisches Steuergerätesignal u(A1), u(B1) und/oder um Code zur Realisierung einer Ermittlungsvorschrift zur Bestimmung des austauschbaren Datums r1 aus den zugehörigen virtuellen physikalischen Steuergerätesignalen u(A1), u(B1).

Der von der virtuellen Steuergeräte-Pin-Einheit 9 generierte Code kann abschließend zusammen mit dem der Code des virtuellen Steuergeräts 2 und dem Code der Simulationsumgebung 3 in einer gemeinsamen Simulation ausgeführt werden, wobei es sich bei der Simulation insbesondere um eine Echtzeitsimulation handelt.

## Patentansprüche

1. Testeinrichtung (1) zum Test zumindest eines Teils eines virtuellen Steuergeräts (2) mit einer Simulationsumgebung (3) in einem Simulator, die Testeinrichtung (1) aufweisend das virtuelle Steuergerät (2) und die Simulationsumgebung (3), wobei das virtuelle Steuergerät (2) wenigstens eine Software-Komponente (4, 5, 6) mit wenigstens einer äußeren Datenschnittstelle (7) umfasst, wobei die Simulationsumgebung (3) wenigstens eine Datenschnittstelle (8) zum zumindest mittelbaren Datenaustausch mit dem virtuellen Steuergerät (2) umfasst,
**dadurch gekennzeichnet,**
**dass** die Testeinrichtung (1) eine virtuelle Steuergeräte-Pin-Einheit (9) umfasst,
**dass** die virtuelle Steuergeräte-Pin-Einheit (9) wenigstens eine virtuelle Steuergeräteschnittstelle (10) aufweist und mittels der virtuellen Steuergeräteschnittstelle (10) zumindest mit der äußeren Datenschnittstelle (7) der Software-Komponente (4) des virtuellen Steuergeräts (2) verbunden ist,
**dass** die virtuelle Steuergeräte-Pin-Einheit (9) wenigstens eine Simulationsumgebungsschnittstelle (11) aufweist und mittels der Simulationsumgebungsschnittstelle mit der Datenschnittstelle (8) der Simulationsumgebung (3) verbunden ist und
**dass** die virtuelle Steuergeräte-Pin-Einheit (9) wenigstens einen virtuellen Steuergeräte-Pin (12) aufweist, der mit einem Pin der physikalischen Schnittstelle eines zu simulierenden realen Steuergeräts derart korrespondiert, dass über den virtuellen Steuergeräte-Pin (12) ein virtuelles physikalisches Steuergerätesignal, das in Datenform wertemäßig ein physikalisches Steuergerätesignal eines Pins einer physikalischen Schnittstelle beschreibt, übertragbar ist.

2. Testeinrichtung (1) nach Anspruch 1, **dadurch gekennzeichnet, dass** die Simulationsumgebungsschnittstelle (11) der virtuellen Steuergeräte-Pin-Einheit (9) zumindest einen virtuellen Steuergeräte-Pin (12) aufweist, so dass über die Datenschnittstelle (8) der Simulationsumgebung (3) auch virtuelle physikalische Steuergerätesignale übertragen werden.

3. Testeinrichtung (1) nach Anspruch 1 oder 2, **dadurch gekennzeichnet, dass** die Simulationsumgebungsschnittstelle (11) der virtuellen Steuergeräte-Pin-Einheit (9) vollständig aus virtuellen Steuergeräte-Pins (12) gebildet ist, so dass über die Datenschnittstelle (8) der Simulationsumgebung (3) ausschließlich virtuelle physikalische Steuergerätesignale übertragen werden.

4. Testeinrichtung (1) nach Anspruch 1, **dadurch gekennzeichnet, dass** die Simulationsumgebungsschnittstelle (11) der virtuellen Steuergeräte-Pin-Einheit (9) keinen virtuellen Steuergeräte-Pin (12) aufweist, so dass die virtuelle Steuergeräte-Pin-Einheit (9) eine direkte Verbindung zwischen dem virtuellen Steuergerät (2) und der Simulationsumgebung (3) herstellt und die virtuelle Steuergeräte-Pin-Einheit (9) den wenigstens einen virtuellen Steuergeräte-Pin (12) außerhalb der Simulationsumgebungsschnittstelle (11) aufweist.

5. Testeinrichtung (1) nach einem der Ansprüche 1 bis 4, **dadurch gekennzeichnet, dass** die virtuelle Steuergeräte-Pin-Einheit (9) wenigstens eine Korrespondenz (r1:f(A1, B1)) aufweist zwischen einerseits einem zwischen dem virtuellen Steuergerät (2) und/oder der virtuellen Steuergeräte-Pin-Einheit (9) und/oder der Simulationsumgebung (3) austauschbaren Datum (r1) und andererseits der mit der Bestimmung dieses austauschbaren Datums (r1) in Zusammenhang stehender virtueller Steuergeräte-Pins (A1, B1).

6. Testeinrichtung (1) nach Anspruch 5, **dadurch gekennzeichnet, dass** zu den von der Korrespondenz (r1:f(A1, B1)) umfassten virtuellen Steuergeräte-Pins (12) auch eine Ermittlungsvorschrift zur Bestimmung der zugehörigen virtuellen physikalischen Steuergerätesignale (u(A1), u(B1)) und/oder auch eine Ermittlungsvorschrift zur Bestimmung des Datums r1 aus den zugehörigen virtuellen physikalischen Steuergerätesignalen (u(A1), u(B1)) in der virtuellen Steuergeräte-Pin-Einheit (9) abgelegt ist.

7. Testeinrichtung (1) nach Anspruch 6, **dadurch gekennzeichnet, dass** die Ermittlungsvorschrift zur Bestimmung der zugehörigen virtuellen physikalischen Steuergerätesignale (u(A1), u(B1)) eine zeitabhängige Funktion ist und zur Bestimmung eines zeitabhängigen virtuellen physikalischen Zeitsignals dient, insbesondere in Form eines zeitlich begrenzten Zeitsignals oder eines zeitlich unbegrenzten Zeitsignals.

8. Testeinrichtung (1) nach Anspruch 6, **dadurch gekennzeichnet, dass** die Ermittlungsvorschrift zur Bestimmung des Datums r1 aus den zugehörigen virtuellen physikalischen Steuergerätesignalen (u(A1), u(B1)) zeitabhängige Steuersignale auswertet, insbesondere in Form eines zeitlich begrenzten Zeitsignals oder eines zeitlich unbegrenzten Zeitsignals.

9. Testeinrichtung (1) nach einem der Ansprüche 6 bis 8, **dadurch gekennzeichnet, dass** die Ermittlungsvorschrift eine explizite Berechnungsvorschrift in der virtuellen Steuergeräte-Pin-Einheit (9) ist und/oder wenigstens einen Verweis auf wenigstens eine Berechnungsvorschrift des virtuellen Steuergeräts (2) und/oder wenigstens einen Verweis auf wenigstens eine Berechnungsvorschrift der Simulationsumgebung (3) aufweist.

10. Testeinrichtung (1) nach einem der Ansprüche 1 bis 8, **dadurch gekennzeichnet, dass** in der virtuellen Steuergeräte-Pin-Einheit (9) die Eigenschaften der virtuellen physikalischen Steuergerätesignale spezifiziert sind.

11. Testeinrichtung (1) nach einem der Ansprüche 1 bis 9, **dadurch gekennzeichnet, dass** in der virtuellen Steuergeräte-Pin-Einheit (9) Code generiert wird
zur Verbindung der äußeren Datenschnittstelle (7) und/oder der Datenschnittstelle (8) und/oder
zur Herstellung der Korrespondenz zwischen einerseits einem zwischen dem virtuellen Steuergerät (2) und/oder der virtuellen Steuergeräte-Pin-Einheit (9) und/oder der Simulationsumgebung (3) austauschbaren Datum (r1) und andererseits der mit der Bestimmung dieses austauschbaren Datums (r1) in Zusammenhang stehender virtueller Steuergeräte-Pins (A1, B1) und/oder
zur Realisierung einer Ermittlungsvorschrift und/oder Berechnungsvorschrift zur Bestimmung der zugehörigen virtuellen physikalischen Steuergerätesignale (u(A1), u(B1)) und/oder
zur Realisierung eines zeitabhängigen virtuellen physikalischen Zeitsignals als virtuelles physikalischen Steuergerätesignale (u(A1), u(B1)) und/oder
zur Realisierung einer Ermittlungsvorschrift zur Bestimmung des austauschbaren Datums (r1) aus den zugehörigen virtuellen physikalischen Steuergerätesignalen (u(A1), u(B1)).

12. Testeinrichtung (1) nach einem der Ansprüche 1 bis 11, **dadurch gekennzeichnet, dass** der Code des virtuellen Steuergeräts (2), der Code der Simulationsumgebung (3) und der gemäß Anspruch 11 von der virtuellen Steuergeräte-Pin-Einheit (9) generierte Code in einer gemeinsamen Simulation ausgeführt werden, wobei die Simulation insbesondere eine Echtzeitsimulation ist.

13. Simulator umfassend eine Virtuelle Steuergeräte-Pin-Einheit (9) zur virtuellen Abbildung einer pinbezogenen physikalischen Schnittstelle eines zu simulierenden realen Steuergeräts, wobei die virtuelle Steuergeräte-Pin-Einheit (9) wenigstens eine virtuelle Steuergeräteschnittstelle (10), wenigstens eine Simulationsumgebungsschnittstelle (11) und wenigstens einen virtuellen Steuergeräte-Pin (12) aufweist, wobei mittels der virtuellen Steuergeräteschnittstelle (10) eine Datenverbindung mit wenigstens einer äußeren Datenschnittstelle (7) einer Software-Komponente (4) eines virtuellen Steuergeräts (2) herstellbar ist, wobei mit der Simulationsumgebungsschnittstelle (11) wenigstens eine Datenverbindung mit der Datenschnittstelle (8) einer Simulationsumgebung (3) herstellbar ist und wobei der virtuelle Steuergeräte-Pin (12) mit einem Pin der physikalischen Schnittstelle eines zu simulierenden realen Steuergeräts derart korrespondiert, dass über den virtuellen Steuergeräte-Pin (12) ein virtuelles physikalisches Steuergerätesignal, das in Datenform wertemäßig ein physikalisches Steuergerätesignal einer physikalischen Schnittstelle beschreibt, übertragbar ist.

14. Simulator nach Anspruch 13, **gekennzeichnet durch** die Merkmale der Kennzeichnungsteile wenigstens eines der Ansprüche 2 bis 12.

## Claims

1. A test device (1) for testing at least one part of a virtual control device (2) having a simulation environment (3) in a simulator, the test device (1) comprising the virtual control device (2) and the simulation environment (3), the virtual control device (2) comprising at least one software component (4, 5, 6) comprising at least one external data interface (7), the simulation environment (3) comprising at least one data interface (8) for exchanging data at least indirectly with the virtual control device (2),
**characterized in that,**
the test device (1) comprises a virtual control device pin unit (9),
that the virtual control device pin unit (9) comprises at least one virtual control device interface (10) and is connected at least to the external data interface (7) of the software component (4) of the virtual control device (2) by means of the virtual control device interface (10),
that the virtual control device pin unit (9) comprises at least one simulation environment interface (11) and is connection to the data interface (8) of the simulation environment (3) by means of the simulation environment interface, and
that the virtual control device pin unit (9) comprises at least one virtual control device pin (12) corresponding to a pin of the physical interface of a real control device to be simulated, such that a virtual physical control device signal describing in data form the value of a physical control device signal of a pin of a physical interface can be transmitted via the virtual control device pin (12).

2. The test device (1) according to claim 1, **characterized in that** the simulation environment interface (11) of the virtual control device pin unit (9) comprises at least one virtual control device pin (12), so that virtual physical control device signals can also be transmitted via the data interface (8) of the simulation environment (3).

3. The test device (1) according to claim 1 or 2, **characterized in that** the simulation environment interface (11) of the virtual control device pin unit (9) is formed entirely of virtual control device pins (12), so that exclusively virtual physical control device signals can be transmitted via the data interface (8) of the simulation environment (3).

4. The test device (1) according to claim 1, **characterized in that** the simulation environment interface (11) of the virtual control device pin unit (9) does not comprise any virtual control device pin (12), so that the virtual control device pin unit (9) produces a direct connection between the virtual control device (2) and the simulation environment (3) and the virtual control device pin unit (9) comprises the at least one virtual control device pin (12) outside of the simulation environment interface (11).

5. The test device (1) according to any one of the claims 1 through 4, **characterized in that** the virtual control device pin unit (9) comprises at least one correspondence (r1:f(A1, B1)) between a datum (r1) for exchanging between the virtual control device (2) and/or the virtual control device pin unit (9) and/or the simulation environment (3) on one side and the virtual control device pin (A1, B1) relating to determining said exchangeable datum (r1) on the other side.

6. The test device (1) according to claim 5, **characterized in that** an ascertainment specification for determining the associated virtual physical control device signals (u(A1), u(B1)) and/or an ascertainment specification for determining the datum (r1) from the associated virtual physical control device signals (u(A1), u(B1)) is stored in the virtual control device pin unit (9) in addition to the virtual control device pin (12) comprised by the correspondence (r1:f(A1, B1)).

7. The test device (1) according to claim 6, **characterized in that** the ascertainment specification for determining the associated virtual physical control device signals (u(A1), u(B1)) is a time-dependent function and serves for determining a time-dependent virtual physical time signal, particularly in the form of a time-bounded time signal or an unbounded time signal.

8. The test device (1) according to claim 6, **characterized in that** the ascertainment specification for determining the datum (r1) from the associated virtual physical control device signals (u(A1), u(B1)) evaluates a time-dependent function, particularly in the form of a time-bounded time signal or an unbounded time signal.

9. The test device (1) according to any one of the claims 6 through 8, **characterized in that** the ascertainment specification is an explicit calculation specification in the virtual control device pin unit (9) and/or comprises at least one reference to at least one calculation specification of the virtual control device (2) and/or at least one reference to at least one calculation specification of the simulation environment (3).

10. The test device (1) according to any one of the claims 1 through 8, **characterized in that** the properties of the virtual physical control device signals are specified in the virtual control device pin unit (9).

11. The test device (1) according to any one of the claims 1 through 9, **characterized in that** code is generated in the virtual control device pin unit (9)
for connecting to the external data interface (7) and/or the data interface (8) and/or
for producing the correspondence between a datum (r1) for exchanging between the virtual control device (2) and/or the virtual control device pin unit (9) and/or the simulation environment (3) on one side and the virtual control device pin (A1, B1) relating to determining said exchangeable datum (r1) on the other side, and/or
for implementing an ascertainment specification and/or a calculation specification for determining the associated virtual physical control device signals (u(A1), u(B1)), and/or
for implementing a time-dependent virtual physical time signal as a virtual physical control device signal (u(A1), u(B1)), and/or
for implementing an ascertainment specification for determining the exchangeable datum (r1) from the associated virtual physical control device signals (u(A1), u(B1)).

12. The test device (1) according to any one of the claims 1 through 11, **characterized in that** the code of the virtual control device (2), the code of the simulation environment (3), and the code generated by the virtual control device pin unit (9) according to claim 11 are executed in a common simulation, wherein the simulation is particularly a real-time simulation.

13. A simulator comprising a virtual control device pin unit (9) for virtually representing a pin-based physical interface of a real control device to be simulated, the virtual control device pin unit (9) comprising at least one virtual control device interface (10), at least one simulation environment interface (11), and at least one virtual control device pin (12), a data connection to at least one external data interface (7) of a software component (4) of a virtual control device (2) being able to be established by means of the virtual control device interface (10), at least one data connection to the data interface (8) of a simulation environment (3) being able to be established by means of the simulation environment interface (11), and **characterized in that** the virtual control device pin (12) corresponds to a pin of the physical interface of a real control device to be simulated, such that a virtual physical control device signal describing in data form the value of a physical control device signal of a physical interface can be transmitted via the virtual control device pin (12).

14. The simulator according to claim 13, **characterized by** the features of the characterizing portions of at least one of the claims 2 through 12.

## Revendications

1. Dispositif de test (1) pour tester au moins une partie d'un appareil de commande fictif (2) avec un environnement de simulation (3) dans un simulateur, le dispositif de test (1) comportant l'appareil de commande fictif (2) et l'environnement de simulation (3), dans lequel l'appareil de commande fictif (2) comporte au moins une composante de logiciel (4, 5, 6) avec au moine une interface de données externe (7), dans lequel l'environnement de simulation (3) comporte au moins une interface de données (8) pour l'échange de données au moins indirecte avec l'appareil de commande fictif (2),
**caractérisé en ce que**
le dispositif de test (1) comporte une unité de broche d'appareil de commande fictive (9),
l'unité de broche d'appareil de commande fictive (9) comporte au moins une interface d'appareil de commande fictive (10) et elle est reliée avec au moins l'interface de données externe (7) de la composante de logiciel (4) de l'appareil de commande fictif (2) via l'interface d'appareil de commande fictive (10),
l'unité de broche d'appareil de commande fictive (9) comporte au moine une interface d'environnement de simulation (11) et elle est reliée avec l'interface de données (8) de l'environnement de simulation (3) via l'interface d'environnement de simulation et
l'unité de broche d'appareil de commande fictive (9) comporte au moins une broche d'appareil de commande fictive (12) qui correspond à une broche de l'interface physique d'un appareil de commande réel devant être simulé, de sorte que soit transmissible, via la broche d'appareil de commande fictive (12), un signal d'appareil de commande physique fictif qui, sous forme de données, décrit en valeur un signal d'appareil de commande physique d'une broche d'une interface physique.

2. Dispositif de test (1) selon la revendication 1, **caractérisé en ce que** l'interface d'environnement de simulation (11) de l'unité de broche d'appareil de commande fictive (9) comporte au moins une broche d'appareil de commande fictive (12), de sorte que des signaux d'appareil de commande physiques fictifs soient également transmis via l'interface de données (8) de l'environnement de simulation (3).

3. Dispositif de test (1) selon la revendication 1 ou 2, **caractérisé en ce que** l'interface d'environnement de simulation (11) de l'unité de broche d'appareil de commande fictive (9) est formée complètement par des broches d'appareil de commande fictifs (12), de sorte que soient transmis exclusivement des signaux d'appareil de commande physiques fictifs via l'interface de données (8) de l'environnement de simulation (3).

4. Dispositif de test (1) selon la revendication 1, **caractérisé en ce que** l'interface d'environnement de simulation (11) de l'unité de broche d'appareil de commande fictive (9) ne comporte aucune broche d'appareil de commande fictive (12), de sorte que l'unité de broche d'appareil de commande fictive (9) établit une liaison directe entre l'appareil de commande fictif (2) et l'environnement de simulation (3) et l'unité de broche d'appareil de commande fictive (9) comporte l'au moins une d'appareil de commande fictive (12) hors de l'interface d'environnement de simulation (11).

5. Dispositif de test (1) selon l'une des revendications 1 à 4, **caractérisé en ce que** l'unité de broche d'appareil de commande fictive (9) présente au moins une correspondance (r1 :f(A1, B1)) entre, d'une part, une date (r1) échangeable entre l'appareil de commande fictif (2) et/ou l'unité de broche d'appareil de commande fictive (9) et/ou l'environnement de simulation (3) et, d'autre part, la broche d'appareil de commande fictive (A1, B1) en relation avec la détermination de cette date échangeable (r1).

6. Dispositif de test (1) selon la revendication 5, **caractérisé en ce que**, en plus des broches d'appareil de commande fictives (12) compris dans la correspondance (r1:f(A1, B1), une prescription de détermination pour déterminer les signaux d'appareils de commande (u(A1), u(B1)) physiques fictifs connexes et/ou une prescription de détermination pour déterminer la date r1 à partir des signaux d'appareils de commande (u(A1), u(B1)) physiques fictifs connexes est/sont également stockée(s) dans l'unité de broche d'appareil de commande fictive (9).

7. Dispositif de test (1) selon la revendication 6, **caractérisé en ce que** la prescription de détermination pour déterminer les signaux d'appareils de commande (u(A1), u(B1)) physiques fictifs connexes est une fonction dépendante du temps et sert à déterminer un signal horaire physique fictif dépendant du temps, en particulier sous forme d'un signal horaire limité dans le temps ou d'un signal horaire non limité dans le temps.

8. Dispositif de test (1) selon la revendication 6, **caractérisé en ce que** la prescription de détermination pour déterminer la date r1 à partir des signaux d'appareils de commande (u(A1), u(B1)) physiques fictifs connexes analyse des signaux de commande dépendants du temps, en particulier sous forme d'un signal horaire limité dans le temps ou d'un signal horaire non limité dans le temps.

9. Dispositif de test (1) selon l'une des revendications 6 à 8, **caractérisé en ce que** la prescription de détermination est une prescription de calcul dans l'unité de broche d'appareil de commande fictive (9) et/ou présente au moins une référence à au moins une prescription de calcul de l'appareil de commande fictif (2) et/ou au moins une référence à au moins une prescription de calcul de l'environnement de simulation (3).

10. Dispositif de test (1) selon l'une des revendications 1 à 8, **caractérisé en ce que** les caractéristiques des signaux d'appareil de commande physiques fictifs sont spécifiées dans l'unité de broche d'appareil de commande fictive (9).

11. Dispositif de test (1) selon l'une des revendications 1 à 9, **caractérisé en ce que** dans l'unité de broche d'appareil de commande fictive (9), un code est généré
pour mettre en liaison l'interface de données externe (7) et/ou l'interface de données (8) et/ou
pour établir la correspondance entre, d'une part, une date (r1) échangeable entre l'appareil de commande fictif (2) et/ou l'unité de broche d'appareil de commande fictive (9) et/ou l'environnement de simulation (3) et, d'autre part, la broche d'appareil de commande fictive (A1, B1) en relation avec la détermination de cette date échangeable (r1) et/ou
pour réaliser une prescription de détermination et/ou prescription de calcul en vue de déterminer les signaux d'appareil de commande physiques fictifs connexes (u(A1), u(B1)) et/ou
pour réaliser un signal horaire physique fictif dépendant du temps en tant que signal d'appareil de commande physique fictif (u(A1), u(B1)) et/ou
pour réaliser une prescription de détermination en vue de déterminer la date échangeable (r1) à partir des signaux d'appareil de commande physiques fictifs connexes (u(A1), u(B1)).

12. Dispositif de test (1) selon l'une des revendications 1 à 11, **caractérisé en ce que** le code de l'appareil de commande fictif (2), le code de l'environnement de simulation (3) et le code généré par l'unité de broche d'appareil de commande fictive (9) selon la revendication 11 sont exécutés dans une simulation commune, sachant que la simulation est en particulier une simulation en temps réel.

13. Simulateur comprenant une unité de broche d'appareil de commande fictive (9) pour l'illustration fictive d'une interface physique propre à une broche, d'un appareil de commande réel devant être simulé, dans lequel l'unité de broche d'appareil de commande fictive (9) présente au moins une interface d'appareil de commande fictive (10), au moins une interface d'environnement de simulation (11) et au moins une broche d'appareil de commande fictive (12), dans lequel une connexion de données peut être établie à l'aide de l'interface d'appareil de commande fictive (10) avec au moins une interface de données externe (7) d'un composant de logiciel (4) d'un appareil de commande fictif (2), dans lequel avec l'interface d'environnement de simulation (11), au moins une connexion de données peut être établie avec l'interface de données (8) d'un environnement de simulation (3) und dans lequel la broche d'appareil de commande fictive (12) correspond à une broche de l'interface physique d'un appareil de commande réel devant être simulé, de sorte que soit transmissible, via la broche d'appareil de commande fictive (12), un signal d'appareil de commande physique fictif qui, sous forme de données, décrit en valeur un signal d'appareil de commande physique d'une interface physique.

14. Simulateur selon la revendication 13, **caractérisé par** les caractéristiques des parties de caractérisation au moins de l'une des revendications 2 à 12.
